Europäisches Patentamt

European Patent Office

Office européen des brevets

(11) Numéro de publication: **0 236 169 B1**

(12) **FASCICULE DE BREVET EUROPEEN**

(45) Date de publication de fascicule du brevet:
**09.10.91**

(21) Numéro de dépôt: **87400162.1**

(22) Date de dépôt: **23.01.87**

Demande divisionnaire 87200973 déposée le
25.05.87.

(51) Int. Cl.⁵: **G02F 1/133, H01L 29/78**

(54) **Procédé de fabrication d'un écran d'affichage à matrice active à résistance de grille.**

(30) Priorité: **27.01.86 FR 8601083**

(43) Date de publication de la demande:
**09.09.87 Bulletin 87/37**

(45) Mention de la délivrance du brevet:
**09.10.91 Bulletin 91/41**

(84) Etats contractants désignés:
**BE CH DE GB IT LI NL SE**

(56) Documents cités:
**EP-A- 0 103 523**

**PATENT ABSTRACTS OF JAPAN, vol. 9, no.
181 (E-331)[1904], 26 juillet 1985; & JP-A-60 52
057**

(73) Titulaire: **Maurice, François**
**125 Boulevard de la Corniche**
**F-22700 Perros-Guirec(FR)**

Titulaire: **Richard, Joseph**
**33 Lotissement Keranroux Ploubezre**
**F-22300 Lannion(FR)**

Titulaire: **Vinouze, Bruno**
**Chemin de la Chapelle**
**F-22710 Port Blanc(FR)**

(72) Inventeur: **Maurice, François**
**125 Boulevard de la Corniche**
**F-22700 Perros-Guirec(FR)**
Inventeur: **Richard, Joseph**
**33 Lotissement Keranroux Ploubezre**
**F-22300 Lannion(FR)**
Inventeur: **Vinouze, Bruno**
**Chemin de la Chapelle**
**F-22710 Port Blanc(FR)**

(74) Mandataire: **Mongrédien, André et al**
**c/o BREVATOME 25, rue de Ponthieu**
**F-75008 Paris(FR)**

Rank Xerox (UK) Business Services

## Description

La présente invention a pour objet un procédé de fabrication d'un écran d'affichage à matrice active et à résistance de grille.

Un écran d'affichage à matrice active comprend généralement deux plaques entre lesquelles est intercalé un matériau électrooptique comme un cristal liquide. Sur l'une des plaques, on trouve une matrice de pavés conducteurs transparents, des transistors en couches minces, une famille de lignes conductrices d'adressage et une famille de colonnes conductrices d'adressage. Chaque transistor possède une grille reliée à une ligne, une source reliée à un pavé et un drain relié à une colonne. Sur la seconde plaque, on trouve une contre-électrode.

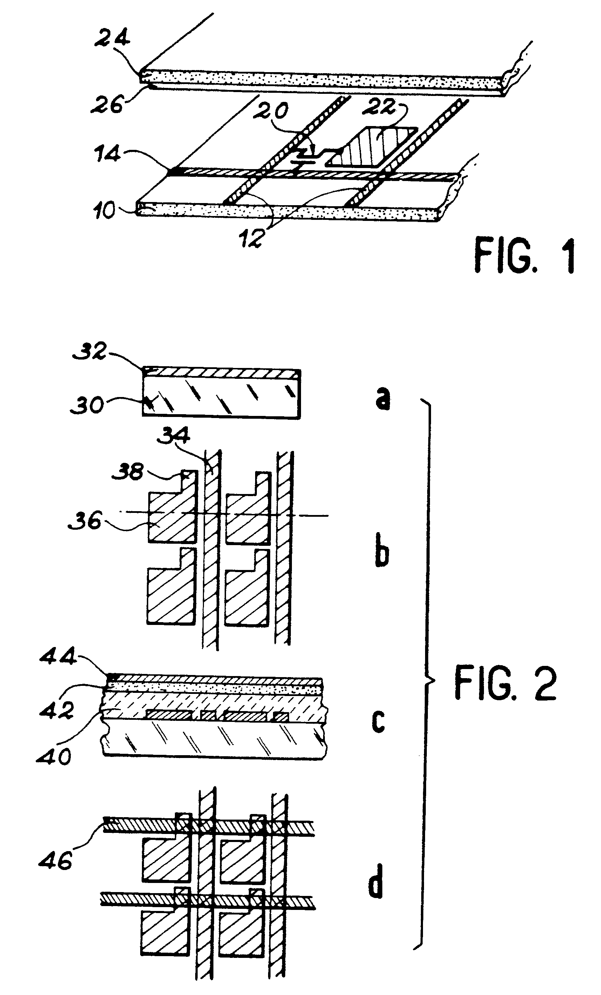

Une telle structure est représentée sur la figure 1. On y a représenté de manière simplifiée une plaque inférieure 10 portant des colonnes conductrices 12, des lignes conductrices 14, des transistors 20 et des pavés conducteurs 22, et une plaque supérieure 24 recouverte d'une contre-électrode 26.

Pour obtenir une telle structure, on peut mettre en oeuvre un procédé dont les principales étapes sont illustrées sur la figure 2. Ce procédé comprend les opérations suivantes :
- préparation d'un substrat de verre 30 par nettoyage physico-chimique,
- dépôt d'une couche 32 de matériau conducteur transparent, par exemple en oxyde d'étain et d'indium (ITO) (partie a),
- première photogravure, pour donner à la couche 32 la forme de colonnes 34 et de pavés 36 munis d'un appendice rectangulaire 38 (partie b),
- dépôts d'une couche de silicium amorphe hydrogéné 40, d'une couche de silice 42 et d'une couche d'aluminium 44, chaque dépôt étant effectué à environ 250° C (ou plus si on utilise la technique de CVD-plasma) (partie c),
- seconde photogravure, pour définir des lignes 46 chevauchant les appendices 38 et croisant les colonnes, ce qui définit les transistors (partie d),
- passivation générale par dépôt d'une couche de SiO₂ (non représentée).

Un tel procédé, à deux niveaux de masquage, est décrit dans la demande de brevet français FR-A-2 533 072.

Malgré sa simplicité, ce procédé présente des inconvénients :
- tout d'abord, en cas de court-circuit drain-grille d'un transistor, une colonne entière se trouve en court-circuit avec une ligne,
- ensuite, la largeur d'une ligne, dans la zone où celle-ci croise une colonne, est déterminée par la largeur du canal du transistor, de sorte qu'on ne peut la réduire à volonté dans le but de diminuer les risques de court-circuit ligne-colonne,
- enfin, l'épaisseur de l'isolant qui sépare une ligne et une colonne est, par construction même, la même que celle de l'isolant situé sous la grille du transistor, de sorte que, là non plus, on n'est pas maître de l'accroissement de cette épaisseur si l'on veut réduire les risques de court-circuit.

Le but de l'invention est justement de remédier à ces inconvénients. A cette fin, l'invention, telle que revendiquée dans les revendications 1 et 4, préconise l'utilisation d'une couche de matériau résistif placée sous la grille des transistors. Ainsi, en cas de défaut (par exemple en cas de percement) dans l'isolant du transistor, il n'y a pas court-circuit franc entre la ligne et la colonne correspondante.

Par ailleurs, selon l'invention le drain du transistor n'est pas constitué par la colonne proprement dite, mais par un segment relié à cette colonne. De cette manière, il y a relative indépendance entre les transistors et les zones de croisement lignes-colonnes, de sorte que l'épaisseur de l'isolant de croisement peut être rendue supérieure celle de l'isolant du transistor.

De toutes façons, les caractéristiques de l'invention apparaîtront mieux à la lecture de la description qui va suivre, d'exemples de réalisation donnés à titre explicatif et nullement limitatif. Cette description se réfère à des dessins annexés sur lesquels :
- la figure 1, déjà décrite, montre la structure d'un écran d'affichage à matrice active selon l'art antérieur,
- la figure 2, déjà décrite, illustre un procédé de fabrication connu utilisé pour fabriquer un écran d'affichage à matrice active,
- la figure 3 représente un schéma électrique équivalent d'un élément d'affichage selon l'invention,
- la figure 4 montre les principales étapes d'un procédé de fabrication selon l'invention utilisant trois niveaux de masquage,
- la figure 5 montre une coupe obtenue dans la zone du canal d'un transistor,
- la figure 6 montre une coupe obtenue sur une colonne,
- la figure 7 montre une coupe obtenue sur une ligne,

- la figure 8 montre une coupe obtenue au croisement d'une ligne et d'une colonne,
- la figure 9 montre un détail des deux couches métalliques supérieures,
- la figure 10 illustre un autre procédé de réalisation de l'écran d'affichage de l'invention, utilisant seulement deux niveaux de masquage.

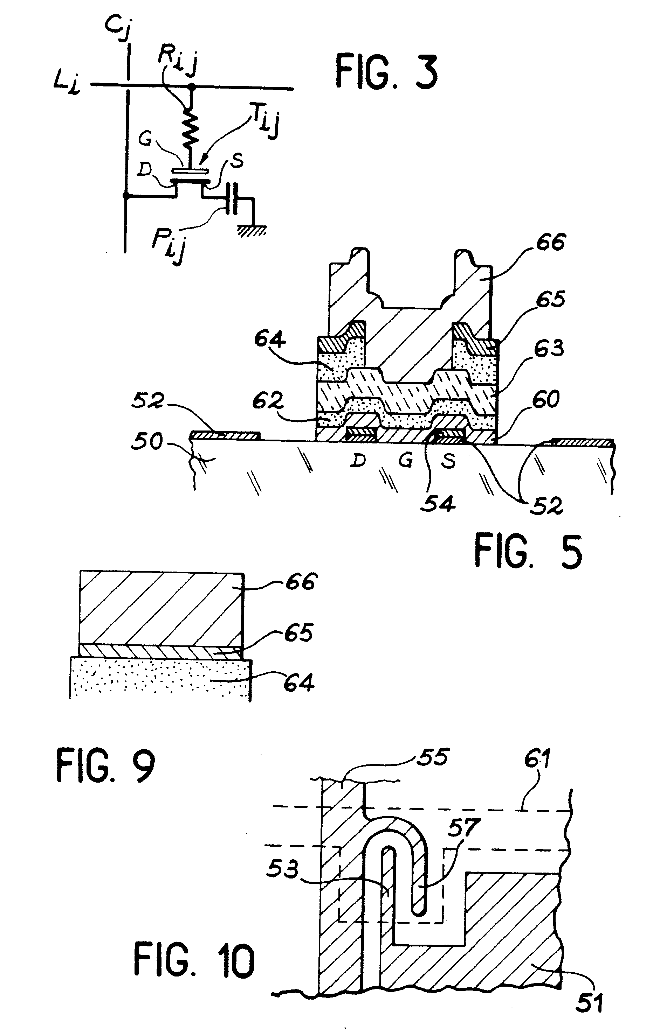

La figure 3 représente un schéma électrique équivalent d'un point d'affichage d'un écran conforme à l'invention. On y voit un point d'affichage (ou "eldim" ou "pixel") Pij formé d'un condensateur dont l'une des armatures est portée à un potentiel de référence et l'autre reliée à un transistor Tij. Celui-ci comprend une grille G, une source S et un drain D. On voit, par ailleurs, une ligne d'adressage Li et une colonne d'adressage Cj. La grille G du transistor est reliée à la ligne Li par une résistance Rij, la source S au condensateur, et le drain D à la colonne Cj. La valeur R de la résistance de grille doit être très supérieure à l'impédance de sortie des circuits de commande de l'écran et telle que la constante de temps RC ou C désigne la capacité de la grille du transistor, soit très inférieure au temps de balayage d'une ligne.

Par exemple, ce temps T peut être de 64 $\mu$s et C peut être égal à $5.10^{-13}$ F. On pourra alors prendre une résistance R dans la plage allant de $10^5$ à $2.10^7 \Omega$.

Pour obtenir une telle résistance on peut utiliser une couche résistive de silicium amorphe fortement dopé n ayant une épaisseur d'un dixième de $\mu$m, ou plus. Pour une grille de 2 $\mu$m par 7 $\mu$m, cela correspond à une résistance transverse de l'ordre de

$$R = \rho \frac{l}{s} = 1,4 . 10^4 \frac{10^{-4}}{2 \times 7 . 10^{-6}} = 10^5 \Omega$$

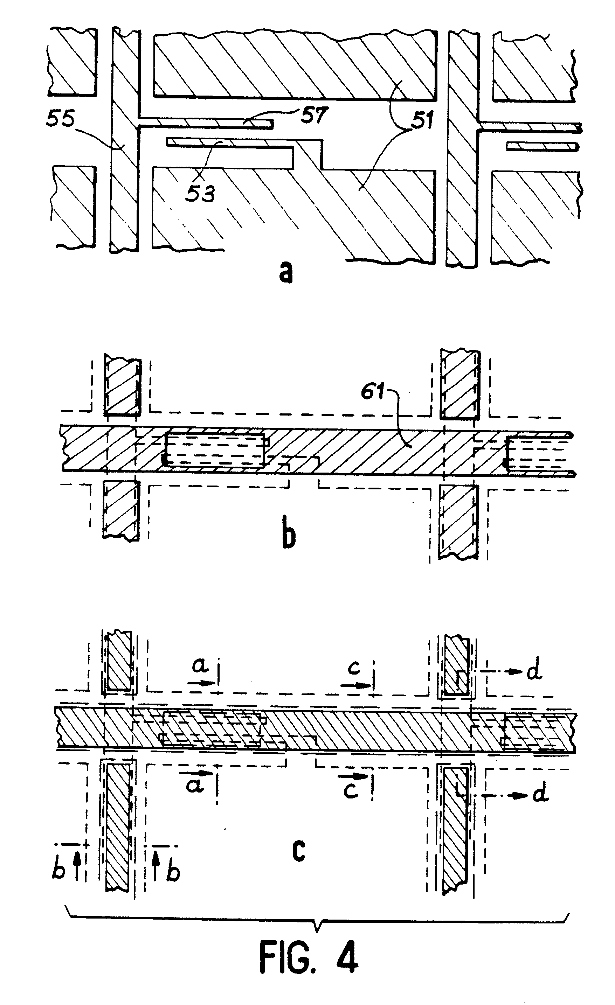

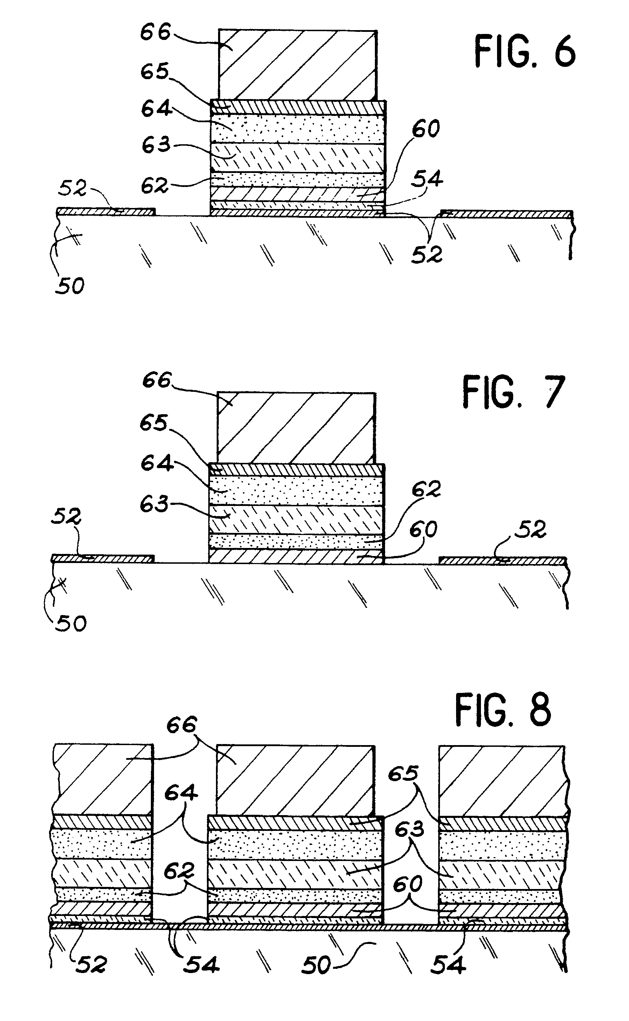

La figure 4 montre trois étapes (parties a, b, c) d'un procédé de fabrication à trois niveaux de masquage. On pourra se reporter aussi aux figures 6, 7 et 8 qui montrent en coupe les différentes couches déposées. Les opérations effectuées sont les suivantes :

- dépôt sur un support isolant 50, en verre par exemple, d'une couche d'un matériau conducteur transparent 52, par exemple en oxyde d'étain et d'indium ITO, et éventuellement d'une couche 54 de silicium amorphe dopé $n^+$, (voir en particulier les figures 6, 7 et 8),
- première photogravure de cette ou ces couches pour former des pavés 51 reliés à un segment 53, des colonnes 55 reliées à un autre segment 57 parallèle au premier (partie a de la figure 4),
- dépôt d'un empilement constitué par une couche 60 de silicium amorphe hydrogéné aSi:H, d'une couche 62 d'un premier isolant (par exemple en $SiO_2$), puis d'une couche 63 de silicium amorphe fortement dopé n ($aSin^+$) constituant la future résistance de grille, d'une couche 64 d'un second isolant, non nécessairement identique au premier mais pouvant l'être, et d'une couche 65 d'un premier métal (figures 6, 7, 8),
- deuxième photogravure appliquée à cet empilement pour dégager les pavés et les zones où auront lieu les croisements avec les lignes, mais laissant subsister cet empilement le long de lignes 61 intercalées entre les pavés, ces lignes chevauchant les deux segments 53 et 57, cette deuxième photogravure laissant subsister également cet empilement sur les colonnes, sauf naturellement à l'endroit où ces colonnes croisent les lignes. Cette deuxième photogravure n'est que partielle entre les deux segments et fait disparaître la couche de métal 65 et celle du second isolant 64 et fait apparaître ainsi la couche 63 de silicium amorphe fortement dopé, constituant la future résistance de grille ; le second niveau de gravure est représenté en traits pleins sur la partie b de la figure 4, le premier niveau de masquage étant représenté en tireté,
- dépôt d'une couche 66 d'un second métal,
- troisième photogravure appliquée à cette dernière couche pour ne la laisser subsister que sur les lignes, ce qui établit le contact entre la couche 63 de silicium amorphe fortement dopé et les lignes déjà formées, cette troisième photogravure laissant également subsister le second métal sur ce qui reste du premier métal 65 sur les colonnes (les parties obtenues après cette troisième photogravure sont représentées en traits pleins sur la partie c de la figure 4).

Une meilleure compréhension de la structure finale peut être obtenue en examinant la figure 5, qui est une coupe à travers le canal du transistor (coupe aa de la figure 4c), la figure 6, qui est une coupe en travers d'une colonne (coupe bb), la figure 7, qui est une coupe en travers d'une ligne (coupe cc) et la figure 8 qui est une coupe dans la zone de croisement ligne-colonne (coupe dd).

On observera que le second isolant 64 subsiste au croisement ligne-colonne alors qu'il est supprimé sous la grille du transistor où seul le premier isolant 62 est présent. On pourra donc donner à l'isolant 62 l'épaisseur requise pour assurer de bonnes performances au transistor tout en employant un isolant 64 assez épais pour assurer l'isolement lignes-colonnes.

Sur les figures 7 et 8, on notera que la largeur des lignes du second métal 66 est inférieure à la largeur des lignes du premier métal 65. Cela correspond au cas où ces deux métaux sont différents et où le premier n'est pas attaqué par la troisième photogravure. Si ces deux métaux sont identiques, les lignes auront même largeur dans les deux niveaux, comme indiqué sur la figure 9. Cette largeur commune sera inférieure à celle de l'isolant 64 qui les supporte, ceci pour réduire les risques de court-circuit par la tranche.

Lorsque les deux métaux 65 et 66 sont différents, la superposition de ces deux couches métalliques produit une redondance qui évite les risques de coupure de ligne : il est en effet quasi-impossible que ces deux couches soient coupées au même endroit.

On notera encore que :
- la marche obtenue au croisement d'une ligne et d'une colonne ne dépend pas de l'épaisseur du second isolant 64, puisqu'elle correspond uniquement à l'épaisseur des couches 52 et 54 obtenues après première photogravure,
- la grille du transistor est définie par masquage ; il n'y a donc pas de transistor parasite entre la grille et la colonne comme dans l'art antérieur,
- l'interface entre la couche de silicium amorphe hydrogéné 60 et la couche de premier isolant 62, ainsi que l'interface entre cette dernière couche et la couche 63 de silicium fortement dopé, ne voient jamais l'air.

Le procédé à trois niveaux de masquage qui vient d'être décrit n'est pas le seul possible. La figure 10 illustre un autre procédé qui fait l'économie d'une photogravure. Les opérations à accomplir commencent, comme pour le premier procédé, par un dépôt, sur un substrat isolant, d'une couche d'un conducteur transparent, ITO par exemple, surmontée d'une couche de silicium amorphe dopé n. Puis est effectuée une première photogravure pour former des pavés 51, avec un appendice 53, des colonnes 55 avec un appendice 57 (en trait plein sur la figure 10). Est déposé ensuite un empilement constitué par une couche de silicium amorphe hydrogéné, une couche d'un premier isolant, une couche épaisse de silicium amorphe fortement dopé $n^+$ (qui constitue la couche résistive) et une couche métallique. Autrement dit, on ne dépose plus la couche du second isolant, ni la couche du premier métal, mais on intercale directement la couche résistive entre le métal de grille et le premier isolant. Cet empilement fait l'objet d'une seconde photogravure pour laisser subsister des lignes 61 et une grille au-dessus des deux appendices 53, 57 (en tirets sur la figure 10).

Par rapport à un procédé à deux niveaux de masquage tel que celui qui est décrit dans le document FR-A-2 533 072, le procédé qui vient d'être décrit présente les avantages suivants :
- un court-circuit ponctuel dans l'isolant du transistor se trouve placé en série avec la résistance formée par la couche de aSi:$n^+$ et qui est de l'ordre de $10^7 \Omega$, de sorte que ce défaut ne perturbe pas la ligne ni la colonne au croisement desquelles il se situe. Si le court-circuit est sur le drain du transistor, il ne l'empêche de fonctionner que très localement,
- l'interface isolant-grille ne voit pas l'air,
- la forme particulière de l'appendice 57 élimine le transistor parasite qui existait entre l'appendice 53 et la colonne suivante,
- une forte épaisseur (supérieure à 0,3 $\mu$m) de aSi:$n^+$ peut adoucir la marche au passage du niveau 1, ce qui réduit d'autant les risques de coupure du métal de grille.

## Revendications

1. Procédé de fabrication d'un écran d'affichage à matrice active, ce procédé consistant à réaliser une paroi inférieure (10) portant des premières armatures (22) de condensateurs et des transistors à couches minces (20), des lignes (14) et des colonnes (12) conductrices d'adressage, et une paroi supérieure (24) revêtue d'une contre-électrode (26) formant seconde armature des condensateurs, ce procédé comprenant, pour réaliser la paroi inférieure (10), les opérations suivantes :
   - dépôt sur un substrat isolant (50) d'une couche d'un premier matériau conducteur transparent (52), éventuellement surmontée d'une couche de silicium amorphe dopé n (54),
   - première photogravure pour constituer des pavés (51) formant une des armatures des futurs condensateurs et des colonnes (55),
   - dépôt d'un empilement constitué par une couche de silicium amorphe hydrogéné (60) et une couche d'un premier isolant (62),
   - dépôt d'une couche d'un second métal (66),

4

EP 0 236 169 B1

ce procédé étant caractérisé par le fait que :
- la première photogravure laisse subsister également à côté de chaque pavé deux segments parallèles (53, 57), l'un (57) constituant le futur drain du transistor et relié à la colonne adjacente (55) et l'autre (53) constituant la future source du transistor et relié au pavé en question (51),
- l'empilement déposé est constitué, en outre, d'une couche de silicium amorphe fortement dopé $n^+$ (63) constituant la future résistance de grille, d'une couche d'un second isolant (64), d'une couche d'un premier métal (65),
- une deuxième photogravure est appliquée à l'empilement pour dégager les pavés (51) mais laisser subsister cet empilement le long de lignes intercalées entre les pavés, ces lignes chevauchant les deux segments parallèles (53, 57) et laisser subsister cet empilement sur les colonnes sauf à l'endroit où ces colonnes croisent les lignes, cette seconde photogravure n'étant que partielle dans la zone située entre les deux segments et faisant disparaître la couche du premier métal (65) et du second isolant (64) et faisant apparaître la couche de silicium amorphe fortement dopé (63) constituant la résistance de grille,
- une troisième photogravure est appliquée à la couche de second métal (66) pour laisser subsister les lignes, ce qui établit le contact entre la couche de silicium amorphe fortement dopé (63) et les lignes, cette troisième photogravure laissant également subsister le second métal sur ce qui reste du premier métal sur les colonnes.

2. Procédé selon la revendication 1, caractérise par le fait que le premier métal (65) et le second métal (66) sont différents, la largeur des bandes du second métal (66) qui subsistent après la troisième gravure étant plus faible que la largeur des bandes du premier métal (65) qui subsistent après la deuxième photogravure.

3. Procédé selon la revendication 1, caractérisé par le fait que le premier métal (65) et le second métal (66) sont identiques et que les bandes de ces métaux qui subsistent après les deuxième et troisième photogravures ont même largeur, celle-ci étant inférieure à la largeur des bandes du second matériau isolant (64) qui subsistent après la deuxième photogravure.

4. 4. Procédé de fabrication d'un écran d'affichage à matrice active, ce procédé consistant à réaliser une paroi inférieure (10) portant des premières armatures (22) de condensateurs et des transistors à couches minces (20), des lignes (14) et des colonnes (12) conductrices d'adressage, et une paroi supérieure (24) revêtue d'une contre-électrode (20) formant seconde armature des condensateurs, ce procédé comprenant, pour réaliser la paroi inférieure (10), les opérations suivantes :
- dépôt sur un substrat isolant (50) d'une couche d'un premier matériau conducteur transparent (52) éventuellement surmontée d'une couche de silicium amorphe dopé n (54),
- première photogravure pour constituer des pavés (51) formant des armatures des futurs condensateurs et des colonnes (55),
- dépôt d'un empilement constitué par une couche de silicium amorphe hydrogéné (60), d'une couche d'un premier isolant (62),
ce procédé étant caractérisé par le fait que :
- la première photogravure constitue en outre deux segments parallèles (53, 57) l'un (57) constituant le futur drain du transistor et relié à la colonne adjacente (55) et l'autre (53) constituant la future source du transistor et relié au pavé (51),
- l'empilement déposé comprend en outre une couche de silicium amorphe fortement dopé $n^+$ (63) constituant la future résistance de grille et d'une couche métallique (66),
- une seconde photogravure est appliquée à l'empilement pour laisser subsister des lignes (61) et des grilles au-dessus des deux segments (53, 57).

## Claims

1. Process for the production of an active matrix display screen, said process consists of producing a lower wall (10) carrying first capacitor plates (22) and thin film transistors (20), addressing conductive columns (12) and lines (14) and an upper wall (24) covered by a counterelectrode (26) forming the second capacitor plate, said process comprising, for producing the lower wall (10), the following operations:
deposition on an insulating substrate (50) of a layer of a first transparent conductive material (52), optionally surmounted by a n doped amorphous silicon layer (54),

5

first photoetching to constitute blocks (51) forming one of the plates of the future capacitors and columns (55),

deposition of a stack constituted by a hydrogenated amorphous silicon layer (60) and a layer of a first insulant (62),

deposition of a layer of a second metal (66),

said process being characterized in that:

the first photoetching leaves behind alongside each block, two parallel segments (53), one (57) constituting the future transistor drain and connected to the adjacent column (55) and the other (53) constituting the future transistor source and connected to the block in question (51),

the deposited stack is also constituted by a highly $n^+$ doped amorphous silicon layer (63) constituting the future gate resistance, a layer of a second insulant (64) and a layer of a first metal (65),

a second photoetching is applied to the stack in order to free the blocks (51), but leaving behind the said stack along lines interposed between the blocks, said lines overlapping the two parallel segments (53, 57) and leaving behind said stack on the columns, except at the location where said columns cross said lines, said second photoetching only being partial in the zone located between the two segments and leading to the disappearance of the layer of the first metal (65) and the second insulant (64) and leading to the appearance of the highly doped amorphous silicon layer (63) constituting the gate resistance,

a third photoetching is applied to the second metal layer (66) so as to leave behind the lines, which establishes the contact between the highly doped amorphous silicon layer (63) and the lines, said third photoetching also leaving behind the second metal on what is left of the first metal on the columns.

2. Process according to claim 1, characterized in that the first metal (65) and the second metal (66) are different, the width of the strips of the second metal (66) left after the third etching being smaller than the width of the strips of the first metal (65) left after the second photoetching.

3. Process according to claim 1, characterized in that the first metal (65) and the second metal (66) are identical and that the strips of these metals left behind after the second and third photoetching processes have the same width, which is less than the width of the strips of the second insulating material (64) left behind after the second photoetching process.

4. Process for the production of an active matrix display screen, said process consisting of producing a lower wall (10) carrying first capacitor plates (22) and thin film transistors (20), conductive addressing columns (12) and lines (14) and an upper wall (24) covered by a counterelectrode (20) forming the second capacitor plate, said process comprising, for producing the lower wall (10), the following operations:

deposition on an insulating substrate (50) of a layer of a first transparent conductive material (52) optionally surmounted by a n doped amorphous silicon layer (54),

first photoetching in order to form blocks (51) constituting the plates of the future capacitors and columns (55),

deposition of a stack constituted by a hydrogenated amorphous silicon layer (60), a layer of a first insulant (62),

said process being characterized in that:

the first photoetching also forms two parallel segments (53, 57), one (57) constituting the future transistor drain and connected to the adjacent column (55) and the other (53) constituting the future transistor source and connected to the block (51),

the deposited stack also comprises a highly $n^+$ doped amorphous silicon layer (63) constituting the future gate resistance and a metal layer (66),

a second photoetching being applied to the stack so as to leave behind lines (61) and gates above the two segments (53, 57).

**Patentansprüche**

1. Verfahren zur Herstellung eines Anzeigeschirms mit aktiver Matrix, umfassend das Erstellen einer unteren Schicht (10), die erste Kondensatorelektroden (22) und Dünnschichttransistoren (20), leitfähige Adressleitungen (14) und -spalten (12) trägt und einer oberen Schicht (24), die von einer Gegenelektrode (26) bedeckt ist, die die zweite Kondensatorelektrode bildet, umfassend für die Erstellung der unteren Schicht (10) die folgenden Vorgänge:

das Abscheiden einer Schicht aus einem ersten transparenten Leitermaterial (52) gegebenenfalls bedeckt von einer amorphen, n-dotierten Siliziumschicht (54) auf ein isolierendes Substrat (50),

eine erste Photoätzung zum Ausbilden von Flecken (51), die eine der Elektroden zukünftiger Kondensatoren und Spalten (55) bilden,

das Abscheiden eines Laminats aus einer wasserstoffangereicherten amorphen Siliziumschicht (60) und einer ersten Isolierschicht (62),

das Abscheiden einer Schicht aus einem zweiten Metall (66), **dadurch gekennzeichnet, daß**

die erste Photoätzung auch auf Seiten eines jeden Flecks zwei parallele Segmente (53, 57) zurückläßt, von denen das eine das zukünftige Transistordrain bildet und mit der benachbarten Spalte (55) verbunden ist, und das andere die zukünftige Transistorsource bildet und mit dem fraglichen Fleck (51) verbunden ist, wobei das niedergeschlagene Laminat weiterhin aus einer stark $n^+$-dotierten amorphen Siliziumschicht (63), die den zukünftigen Gitterwiderstand bildet, einer zweiten Isolierschicht (64), einer ersten Metallschicht (65) gebildet ist,

eine zweite Photoätzung an dem Laminat ausgeführt wird, um die Flecken (51) freizulegen, dieses Laminat aber längs der zwischen den Flecken angeordneten Leitungen zurückzulassen, welche Leitungen die zwei parallelen Segmente (53, 57) übergreifen, und um dieses Laminat über den Spalten bestehen zu lassen mit Ausnahme der Umgebung, wo die Spalten die Leitungen kreuzen, wobei diese zweite Photoätzung nur teilweise in der Zone stattfindet, die zwischen den zwei Segmenten liegt und die erste Metallschicht (65) und die zweite Isolierschicht (64) verschwinden läßt und die stark dotierte amorphe Siliziumschicht (63) erscheinen läßt, die den Gitterwiderstand bildet,

eine dritte Photoätzung an der zweiten Metallschicht (66) ausgeführt wird, um die Leitungen zurückzulassen, was den Kontakt zwischen der stark dotierten Siliziumschicht (63) und den Leitungen erzeugt, wobei diese dritte Photoätzung auch das zweite Metall zurückläßt, auf dem das erste Metall auf den Spalten verbleibt.

2. Verfahren nach Anspruch 1, **dadurch gekennzeichnet, daß** das erste Metall (65) und das zweite Metall (66) verschieden sind, die Breite der Bänder aus dem zweiten Metall (66), die nach der dritten Ätzung zurückbleiben, kleiner ist als die Bänder aus dem ersten Metall (65), die nach der zweiten Photoätzung zurückbleiben.

3. Verfahren nach Anspruch 1, **dadurch gekennzeichnet, daß** das erste Metall (65) und das zweite Metall (66) identisch sind und daß die Bänder aus diesen Metallen, die nach den zweiten und dritten Photoätzungen zurückbleiben, die gleiche Breite haben, die geringer ist als die Breite der Bänder aus dem zweiten isolierenden Material (64), die nach der zweiten Photoätzung zurückbleiben.

4. Verfahren zum Herstellen eines Anzeigeschirms mit aktiver Matix, umfassend die Erstellung einer unteren Schicht (10), die erste Kondensatorelektroden (22) und Dünnschichtransistoren (20), leitfähige Adressleitungen (14) und -spalten (12) trägt, und einer oberen Schicht (24), die von einer Gegenelektrode (20) bedeckt ist und die zweite Kondensatorelektrode bildet, enthaltend zur Herstellung der unteren Schicht (10) die folgenden Schritte:

Abscheiden einer Schicht aus einem ersten transparenten Leitermaterial (52), auf der sich gegebenenfalls eine Schicht aus n-dotiertem amorphen Silizium (54) befindet, auf einem isolierenden Substrat (50),

eine erste Photoätzung zum Bilden von Flecken (51), die die Elektroden künftiger Kondensatoren und Spalten (55) bilden,

Abscheiden eines Laminats aus einer Schicht aus wasserstoffangereichertem, amorphen Silizium (60) und einer ersten Isolierschicht (62), **dadurch gekennzeichnet, daß**

7

die erste Photoätzung weiterhin zwei parallele Segmente (53, 57) ausbildet, von denen das eine (57) das zukünftige Transistordrain bildet und mit der benachbarten Spalte (55) verbunden ist, und das andere die zukünftige Transistorsource bildet und mit dem Fleck (51) verbunden ist,

das abgeschiedene Laminat weiterhin eine stark $n^+$-dotierte amorphe Siliziumschicht (63) umfaßt, die den zukünftigen Gitterwiderstand bildet, und außerdem eine Metallschicht (66) umfaßt,

eine zweite Photoätzung an dem Laminat ausgeführt wird, um Leitungen (61) und Gitter über den zwei Segmenten (53, 57) zurückzulassen.

FIG. 1

FIG. 2

FIG. 3

FIG. 5

FIG. 9

FIG. 10

**a**

**b**

**c**

# FIG. 4

FIG. 6

FIG. 7

FIG. 8